# EUROPÄISCHE PATENTSCHRIFT

(11) **EP 1 597 781 B1**
(45) Veröffentlichungstag und Bekanntmachung des Hinweises auf die Patenterteilung: **15.02.2012**
(21) Anmeldenummer: 04714784.8
(22) Anmeldetag: 26.02.2004
(51) Int. Cl.: H01L 51/52, H01L 51/56

(54) **VERFAHREN ZUR HERSTELLUNG EINER LICHTEMITTIERENDEN EINRICHTUNG**
METHOD FOR PRODUCING A LIGHT-EMITTING DEVICE
PROCEDE DE FABRICATION D'UN APPAREIL EMETTANT DE LA LUMIERE

(30) Priorität: 26.02.2003 DE 10308515
(43) Veröffentlichungstag der Anmeldung: 23.11.2005
(73) Patentinhaber: SCHOTT AG, 55122 Mainz (DE)
(72) Erfinder: OTTERMANN, Clemens, 65795 Hattersheim (DE); SCHULTHEIS, Bernd, 55270 Schwabenheim (DE); KÖBRICH, Holger, 65439 Flörsheim (DE); HERTEL, Dirk, 65185 Wiesbaden (DE); EFFENBERGER, Ruth, 55278 Undenheim (DE); HAMMERL, Klaus, Michael, DE-84036 Landshut (DE)
(74) Vertreter: Herden, Andreas F.
(86) Internationale Anmeldenummer: PCT/EP2004/001911
(87) Internationale Veröffentlichungsnummer: WO 2004/076230

(56) Entgegenhaltungen:
- EP-A- 0 855 614
- WO-A-98/53510
- WO-A-03/007658
- JP-A- 10 280 170
- US-A- 6 080 606
- US-A1- 2002 127 431
- US-B1- 6 506 616

## Beschreibung

Die Erfindung betrifft ein Verfahren zur Herstellung einer lichtemittierenden Einrichtung im Allgemeinen und zur Herstellung einer lichtemittierenden Einrichtung mittels einer strukturierten Schutzschicht im Speziellen.

Die Strukturierung von Oberflächen, insbesondere in großem Maßstab, stellt eine vielfältige Herausforderung in unterschiedlichsten Bereichen der Werkstofftechnik dar. In Bezug auf lichtemittierende Einrichtungen, insbesondere organische lichtemittierende Einrichtungen oder Dioden (OLED) ergeben sich aufgrund der Besonderheiten, z.B. der Empfindlichkeit der eingesetzten Schichtmaterialien besondere Schwierigkeiten. Die Herstellung strukturierter OLEDs stellt daher eine besondere Herausforderung dar.

Neben mechanischen Verfahren, welche Pressen, Prägen, Fräsen oder mikromechanische Bearbeitung umfassen, sowie thermisch abtragenden Verfahren, z.B. Laserablation, werden in Elektronik, Optoelektronik und Optik (Photonik) Abformungen und Lithographieverfahren zur Oberflächenstrukturierung oder zur lokalen Entfernung von Schichten eingesetzt. Bekannte Techniken zur Erzielung feiner Strukturen mit hoher Reproduzierbarkeit und Ausbeute sind zum Beispiel Photolackverfahren.

Hierbei werden Photolacke mit speziell optimierten Eigenschaften hinsichtlich der Verarbeitbarkeit bzw. deren opto-mechanischem Verhalten, z.B. hinsichtlich der Ausbildung steiler Belichtungskanten, typischerweise aus der Flüssigphase mittels eines geeigneten Verfahrens, z.B. Spincoating, auf die zu strukturierende Bauteiloberfläche aufgetragen und eingetrocknet. Anschließend wird der Lack mittels einer Maske lokal belichtet, wobei sich je nach Art des Lacks eine positive oder negative Struktur erzeugen lässt. Daraufhin wird der Lack entwickelt und über den freizulegenden Bereichen durch ein Lösungsmittel entfernt.

Abschließend wird die gewünschte Struktur über einen Ätzprozess in die Bauteiloberfläche übertragen und schließlich die restliche Lackschicht entfernt.

Ein solches Verfahren ist aus dem US-Patent 5,494,764 bekannt, bei welchem elektronische Bauelemente mittels Aufdrucken einer Photo-Schicht hergestellt werden. Hierbei wird das Bild in einem elektrophotographischen Prozess erzeugt und anschließend wird eine gedruckte Leiterplatte geätzt.

US 6506616 also beschreibt eine organische lichtemittierende Diode, wobei eine Photolacke benutzt wird, um eine Schicht der Diode zu Strukturieren.

Zur Erzeugung gröberer Strukturen können abdeckende Schutzschichten auch mittels Schablonen aufgebracht werden. Ebenfalls werden vorstrukturierte Folien auf die Bauteiloberfläche aufgeklebt.

Die vorstehend beschriebenen Verfahren weisen jedoch insbesondere in Bezug auf die Herstellung lichtemittierender Einrichtungen, insbesondere für Beleuchtungs- oder Leuchtzwecke eine Reihe von Nachteilen auf.

Lithographieverfahren sind sehr teuer und zeitaufwendig und daher insbesondere zur Strukturierung größerer Flächen bei niedrigpreisigen Produkten unwirtschaftlich. Dies liegt insbesondere an dem hohen Preis für die Photolacke und der Notwendigkeit entsprechend großer Beschichtungs- und Belichtungsanlagen.

Die nachteilig langen Prozesszeiten werden durch die Vielstufigkeit des Verfahrens und insbesondere durch die Photolacktrocknung ("bake") und photographische Belichtung verursacht. Typische Prozesszeiten liegen im Bereich von einer Stunde.

Die angesprochenen Schablonen- und Folienverfahren benötigen die Vorfertigung von Masken und Stanzwerkzeugen, die sich erst bei größeren Stückzahlen amortisieren. Dadurch sind die Verfahren der Herstellung kleinerer Stückzahlen höchst unwirtschaftlich.

Ferner sind kleine und komplexe Strukturierungsmuster wie z.B. feine Linien schwierig herzustellen.

Darüber hinaus ist die Herstellung von separierten, nicht zusammenhängenden Strukturen, wie z.B. Innenbereiche von geschlossenen Ringen bei der Herstellung der Werkzeuge und insbesondere bei der Folienübertragung auf die Bauteiloberfläche außerordentlich kritisch, wenn nicht sogar unmöglich.

Weiter ist aus dem US-Patent 5,902,688 eine elektrolumineszente Einrichtung bekannt, bei welcher eine Isolationschicht gemustert ist, um lokal die Lichterzeugung zu blockieren. Bei diesem Verfahren wird ein Transparentfolie mittels eines Laserdruckers hergestellt, um einen Photolack zu belichten. Nachteilig hierbei ist, dass eine separate Maske hergestellt werden muss, was den Prozess kompliziert und unflexibel macht.

Aus der WO 99/50889 sind gedruckte Isolatoren für aktive und passive elektronische Einrichtungen bekannt. Das dort beschriebene Druckverfahren wird jedoch lediglich für Dünnfilm-Transistoren verwendet und andere makroelektronische Schaltkreise eingesetzt.

Aus den US-Patenten 4,661,431; 5,494,764 und 6,080,606 sind Verfahren zum elektrophotographischen Aufdrucken von Toner-Masken zur Herstellung von gedruckten Schaltungsträgern bzw. Dünnfilm-Transistoren bekannt. Die genannten Verfahren eignen sich jedoch nicht zur Herstellung von lichtemittierenden Einrichtungen.

Gleiches gilt für das aus der JP 10-280170 bekannte Verfahren, welches ein elektrophotographisches Aufdrucken einer Ätzmaske auf eine Metalloberfläche beschreibt, die geätzt werden soll. Nachteilig hierbei ist nämlich, dass eine spezielle Zwischenschicht aufgebracht wird, wodurch die Gefahr von Verunreinigungen entsteht. Derartige Schichten können nämlich beim Ausgasen unerwünschte Elemente freisetzen und dadurch die Ausbeute und Standzeit des herzustellenden Bauelements beeinträchtigen. Ferner ist das Verfahren aufwendig und teuer.

In der US 2002/127431 A1 wird ein Verfahren beschrieben, bei welchem eine Indium-Zinn-Oxidschicht abgeschieden und eine Ätzmaske auf dieser Schicht durch Siebdruck hergestellt wird. Für individuelle Anpassungen des Ätzmusters ist dieses Verfahren jedoch nur schlecht geeignet, da für Variationen des Ätzmusters eigens Masken angefertigt werden müssen.

Die EP 0 855 614 A1 offenbart ein Herstellungsverfahren für eine Flüssigkristallanzeige. Dabei wird das Material einer Ätzmaske durch eine Mehrzahl von piezo-elektrischen Düsen ähnlich dem Tintenstrahldruck aufgebracht. Gemäß der EP 0 855 614 A1 kann eine Siliziumschicht oder eine leitfähige Schicht direkt strukturiert und ein lineares Muster mit einer Breite von 10 bis 20 µm erzeugt werden.

Die vorstehend genannten Verfahren sind allerdings insbesondere aufgrund der erwähnten Nachteile für die Herstellung lichtemittierender Einrichtungen teilweise nicht oder nur schlecht geeignet.

Es ist daher eine Aufgabe der vorliegenden Erfindung, ein Verfahren zur Herstellung einer lichtemittierenden Einrichtung zur Verfügung zu stellen, welches einfach und flexibel eine Änderung der gewünschten Struktur erlaubt und mit wirtschaftlich vertretbarem Aufwand die Herstellung kleiner Stückzahlen strukturierter lichtemittierender Einrichtungen von hoher Standzeit und mit hoher Ausbeute ermöglicht.

Eine weitere Aufgabe ist es, ein Verfahren zur Herstellung einer lichtemittierenden Einrichtung zur Verfügung zu stellen, welches die großflächige Herstellung von strukturierten Bauelementen ermöglicht.

Noch eine Aufgabe der Erfindung ist es, ein Verfahren zur Herstellung einer lichtemittierenden Einrichtung zur Verfügung zu stellen, welches schnell und kostengünstig arbeitet.

Eine weitere Aufgabe ist es, ein zur Herstellung einer lichtemittierenden Einrichtung zur Verfügung zu stellen, welches die Herstellung von nicht-zusammenhängenden ineinandergeschachtelten Strukturen ermöglicht.

Noch eine weitere Aufgabe der Erfindung ist es, ein Verfahren zur Herstellung einer lichtemittierenden Einrichtung zur Verfügung zu stellen, welches die Nachteile des Standes der Technik meidet oder zumindest mindert.

Die Aufgabe der Erfindung wird in überraschend einfacher Weise bereits durch den Gegenstand des Anspruchs 1 gelöst. Vorteilhafte Weiterbildungen der Erfindung sind Gegenstand der Unteransprüche.

Erfindungsgemäß wird ein Verfahren zum Strukturieren von Oberflächen vorgeschlagen, bei welchem ein zu strukturierendes Bauelement in Form einer lichtemittierenden Einrichtung bzw. einer Vorform desselben bereit gestellt wird. Auf dem zu strukturierenden Bauelement wird eine strukturierte Schutzschicht erzeugt. Ferner wird das Bauelement oder eine Oberfläche des Bauelements strukturiert, wobei die strukturierte Schutzschicht als Maske, z.B. Ätzmaske dient. Zur Erzeugung der strukturierten Schutzschicht wird die Schutzschicht in strukturiertem oder unstrukturiertem Zustand, insbesondere unmittelbar auf das Bauelement oder eine Oberfläche des zu strukturierenden Bauelements aufgebracht, aufgetragen oder abgeschieden.

Hierzu wird erfindungsgemäß ein Basissubstrat bereit gestellt und zumindest eine erste transparente leitfähige Elektrodenschicht, eine elektrolumineszente Schicht und eine zweite transparente leitfähige Elektrodenschicht aufgebracht, so dass die dem Fachmann grundsätzlich bekannte lichtemittierende Schichtanordnung oder Schichtenfolge gebildet wird.

Weiter wird die strukturierte Schutzschicht auf der lichtemittierenden Einrichtung, genauer in einem Zwischenschritt auf einer ersten der vorgenannten Schichten erzeugt und die lichtemittierende Einrichtung, genauer diese erste Schicht strukturiert, wobei die Schutzschicht auf der besagten ersten Schicht der zu erzeugenden lichtemittierenden Einrichtung aufgebracht wird und auf der ersten Schicht strukturiert fixiert wird.

Dabei ist das strukturierte Fixieren insbesondere dahingehend zu verstehen, dass
- eine bereits vorstrukturierte Schutzschicht oder ein vorstrukturiertes Vorläufermaterial, z.B. ein strukturiert aufgetragenes Pulver, unter Beibehaltung dieser Vorstruktur zumindest zeitweise fest mit der besagten ersten Schicht des Bauelements verbunden, z.B. aufgedruckt, aufgeklebt, eingebrannt, vernetzt oder verschmolzen wird,
- die Schutzschicht unstrukturiert aufgetragen und nachfolgend auf dem Bauelement strukturiert und gleichzeitig fixiert, z.B. eingebrannt, vernetzt oder verschmolzen wird und/oder
- die Strukturierung oder Struktur der Schutzschicht beim oder während dem Aufbringen oder Abscheiden, z.B. durch lokales oder strukturiertes Abscheiden, insbesondere aus einer fluiden Phase, beispielsweise durch Spin Coating, Tauchbeschichtung, ein Gieß- oder Druckverfahren , erst entsteht.

Besonders bewährt hat sich ein Auftragen der Schutzschicht auf das Bauelement in fluider Form. Fluid soll im Lichte dieser Beschreibung nicht nur flüssig oder gasförmig, sondern auch schüttbar, pulverförmig, kolloidal, gelartig oder ähnlich umfassen, also insbesondere formbare oder nicht großflächig fest zusammenhängende Materie. Als Material für die Schutzschicht werden insbesondere ein Zwei-Komponentengemisch, eine Lösung, ein Monomer, ein Polymer, ein Sol-Gel, ein Pulver oder.Nanopartikel verwendet. Aber auch das Aufbringen einer vorzugsweise im Wesentlichen unstrukturierten Folie liegt im Rahmen der Erfindung.

Folglich kann das Aufbringen und strukturierte Fixieren entweder getrennt nacheinander oder gleichzeitig in einem Arbeitsschritt erfolgen. Die Schutzschicht wird aber insbesondere nicht photolithographisch strukturiert.

Vorteilhafterweise ermöglicht die Erfindung geringe Prozesszeiten, hohen Durchsatz und hohe Flexibilität bei der Gestaltung der Schutzschichtstruktur.

Das erfindungsgemäße Verfahren eignet sich in vorteilhafter Weise besonders für die Herstellung kleiner und kleinster Stückzahlen, bei denen im Gegensatz zu hochstrukturierten, fein pixelierten Display-Anwendungen moderate Genauigkeitsanforderungen an die laterale Auflösung gestellt werden. Dies ist insbesondere zur Herstellung großflächiger Schriftzüge oder Symboldarstellungen mit dem erfindungsgemäßen Verfahren wesentlich weniger aufwendig und wirtschaftlicher als mit den bekannten Verfahren zur Strukturierung von OLEDs möglich.

Ferner ist das Verfahren höchst flexibel anwendbar und preiswert, da die Struktur einfach geändert werden kann und auch nicht-photoempfindliches Material für die Schutzschicht verwendbar ist.

Erfindungsgemäß wird die Schutzschicht aufgedruckt, z.B. mittels eines Non-Impact-Druck-Verfahrens aufgebracht. Was im Sinne der Beschreibung als Non-Impact-Druck-Verfahren zu verstehen ist, wird im Folgenden näher erläutert.

Die Bezeichnung "Non-Impact" leitet sich aus dem Gegenteil, nämlich den frühen Matrix- oder Typenraddruckern ab, welche als "Impact-Drucker" bezeichnet werden. Bei diesen Matrix- oder Typenraddruckern werden die Zeichen nämlich durch Aufschlag oder "Impact" einer Type (Typenraddrucker) oder von Nadeln (Matrixdrucker) über ein Farbband auf das Papier übertragen.

Bei einem Non-Impact-Druck-Verfahren werden.die Information nicht durch Aufschlag, sondern z.B. über einen Laser oder eine Leuchtdiodenzeile berührungslos und anschlaglos (daher Non-Impact) auf einen Zwischenträger, z.B. eine mit einer photoleitenden Schicht versehene Trommel, übertragen. Das dort gespeicherte latente oder nicht sichtbare Ladungsbild wird mit spezieller Farbe, dem Toner eingefärbt und dann auf den Nutzträger, z.B. Papier, übertragen. Es besteht also auch beim Non-Impact-Verfahren beim Druck zwar ein Kontakt zwischen dem Informationsfarbträger und dem Nutzträger, aber die Information wird nicht per Schlag übertragen.

Beispiele für bekannte Non-Impact-Verfahren sind:
- Elektrophotographische Verfahren
- Ionographische Verfahren
- Magnetographische Verfahren
- Strahldruck- oder Düsendruckverfahren
- Thermographische Verfahren, insbesondere Thermosublimations- Thermotransfer- oder Lasereinbrandverfahren
- Direct Inductive Printing-Verfahren
- Toner-Jet-Verfahren
- Elcographische Verfahren und
- Zurographische Verfahren.

Bei der erfindungsgemäßen Verwendung eines Non-Impact-Verfahrens oder Non-Impact-Druck-Verfahren ist insbesondere keine feste Druckform oder Belichtungsmaske zur Herstellung der Schutzschicht mit fest eingeprägter Information vorhanden, daher kann von Druck zu Druck eine unterschiedliche Bedruckung oder Struktur übertragen werden. Dies ermöglicht neuartige wirtschaftliche Produktionsarten insbesondere in der Halbleiterindustrie.

Das erfindungsgemäße Verfahren ist also einfach und schnell durchzuführen, da insbesondere auf die Herstellung einer Belichtungsmaske und eines Stanzwerkzeuges verzichtet werden kann.

Vorzugsweise wird also das Aufbringen, Strukturieren und/oder strukturierte Fixieren der Schutzschicht stanzwerkzeuglos, maskenlos und/oder, druckformlos durchgeführt.

Das nachfolgende Strukturieren des Bauelements wird bevorzugt mittels Ätzen bewerkstelligt. Das Ätzen kann nasschemisch oder trocken, z.B. mittels eines Plasmas durchgeführt werden. Dabei erfolgt das Ätzen der Oberfläche des Bauelements insbesondere nach dem Aufbringen der strukturierten Schutzschicht. Nach dem Strukturieren oder Ätzen des Bauelements bzw. seiner Oberfläche wird die Schutzschicht vorzugsweise wieder abgelöst.

Strukturiert ist im Sinne der Beschreibung insbesondere dahingehend zu verstehen, dass die Schutzschicht zumindest zwei Abschnitte aufweist, welche unterschiedlich ausgebildet sind. Z.B. ist der eine Abschnitt undurchlässig und/oder resistent gegen Ätzen während der andere Abschnitt durchlässig ist oder eine Öffnung in der Schutzschicht repräsentiert.

Die Schutzschicht ist insbesondere zwei-dimensional, ggf. sogar drei-dimensional strukturiert.

Folglich ist die strukturierte Schutzschicht eine Ätzmaske.

Demgemäß umfasst die Schutzschicht vorzugsweise ein gegen das Ätzen resistentes und/oder ablösbar fixierbares Material. Das Material enthält z.B. ein Zweikomponentengemisch, Monomere, Polymere, ein Sol-Gel, ein Pulver, Nanopartikel oder ähnliches. Die Schutzschicht kann aber auch flüssig, insbesondere als Lösung, z.B. mittels Spin-Coating oder Tauchbeschichtung oder als Folie aufgebracht werden. Als Material für die Schutzschicht ist insbesondere auch farbiges Material einsetzbar.

Gemäß einer bevorzugten Ausführungsform der Erfindung ist die Schutzschicht zumindest zeitweise, insbesondere vom Zeitpunkt des Aufbringens bis zum Zeitpunkt des Ablösens mit der besagten ersten Schicht oder der zu strukturierenden Oberfläche des Bauelements abschnittsweise oder flächig strukturiert verbunden.

Vorzugsweise wird durch das Fixieren der Schutzschicht die mechanische Haftung der Schutzschicht auf der besagten ersten Schicht des Bauelements strukturiert oder lokal erhöht, was auch bedeuten kann, dass eine Haftung durch das Fixieren überhaupt erst erzeugt wird. Hierzu wird die Schutzschicht insbesondere thermisch, mechanisch, z.B. mittels Verzahnung, unter Einwirkung elektromagnetischer Strahlung, insbesondere Licht oder chemisch reaktiv fixiert, wobei das Fixieren ein Vernetzen, Verkleben, Verschmelzen, Abscheiden und/oder ähnliches umfassen oder sein kann. Vorteilhafter Weise ist somit eine präzise Strukturierung möglich.

Gemäß eines bevorzugten Ausführungsbeispiels umfasst die Schutzschicht ein thermoplastisches oder duroplastisches Material und wird bevorzugt durch Erwärmung über 50°C, über 100°C, über 150°C und/oder unter 500°C, 350°C, 250°C, insbesondere im Bereich um 180°C fixiert.

Durch die moderate Erwärmung werden auch Kunststoffsubstrate und/oder organische Beschichtungen nicht beschädigt.

Ein großer Erfolg des erfindungsgemäßen Verfahrens liegt darin begründet, dass die strukturierte Schutzschicht auch nicht-zusammenhängende und/oder ineinandergeschachtelte Bereiche, z.B. ineinanderliegende geschlossene Formen definieren kann, ohne dass Verbindungsstege notwendig sind. Vorteilhafter Weise wird dadurch die Flexibilität und Gestaltungsvielfalt um ein Vielfaches vergrößert.

Gemäß einer besonders bevorzugten Ausführungsform der Erfindung kann die strukturierte Schutzschicht lokal mit vordefiniert unterschiedlichen Schichtdicken erzeugt werden. Vorzugsweise wird dies durch die Verwendung eines Graudruckverfahrens erzielt, mittels welchem z.B. unterschiedliche oder variierende Schichtdicken innerhalb derselben Schutzschicht im Bereich von etwa 1 µm bis 8 µm erzeugt werden können. Beim Graudruckverfahren wird die Schichtdickenvariation insbesondere während des Aufbringens erzeugt. Alternativ oder ergänzend kann die Schichtdickenvariation auch durch ein lokal unterschiedliches strukturiertes Fixieren, z.B. bei der CVD-Abscheidung erzeugt werden.

Ein weiterer Erfolg des erfindungsgemäßen Verfahrens liegt darin, dass die Struktur der strukturierten Schutzschicht in einem bevorzugt elektronischen Speicher gespeichert sein kann und zum strukturierten Fixieren der Schutzschicht auf dem Bauelement aus dem Speicher geladen wird. Es ist also insbesondere nicht für jede Struktur die Anfertigung einer separaten Belichtungsmaske, wie z.B. bei photolithographischen Verfahren notwendig. Dies vereinfacht die Herstellung und senkt dadurch die Kosten gerade bei kleineren Stückzahlen erheblich.

Ferner kann die Dauer des Verfahrens zwischen dem Bereitstellen des Basissubstrats der lichtemittierenden Einrichtung und dem strukturierten Fixieren der Schutzschicht auf der lichtemittierenden Einrichtung, z.B. auf weniger als 30 min, weniger als 5 min oder weniger als 1 min reduziert werden, so dass vorteilhafter Weise auch großflächige lichtemittierende Einrichtungen mit hohem Durchsatz strukturiert werden können.

Somit können in einem Herstellungsprozess für eine Vielzahl von lichtemittierenden Einrichtungen unterschiedliche lichtemittierende Einrichtungen unmittelbar nacheinander unterschiedlich strukturiert werden. In diesem Fall werden die Verfahrensschritte in dem Herstellungsprozess mehrfach nacheinander durchgeführt, wobei von Einrichtung zu Einrichtung verschiedene Strukturen erzeugt werden können. Dies erfolgt insbesondere durch jeweiliges Laden von unterschiedlichen Strukturen aus dem Speicher.

Zur Herstellung einer strukturierten OLED werden also oder sind auf das Basissubstrat insbesondere eine erste leitfähige Elektrodenschicht, eine Widerstandsschicht, eine Schicht mit einem organischen, elektrolumineszenten Material und/oder eine zweite leitfähige Elektrodenschicht aufgebracht und zumindest eine dieser Schichten, insbesondere die erste leitfähige Elektrodenschicht wird mittels der als Maske wirkenden strukturierten Schutzschicht strukturiert.

Die Herstellung von strukturierten OLEDs ist in der deutschen Patentanmeldung DE 103 08 515 "Verfahren zur Herstellung organischer lichtemittierender Dioden und organische lichtemittierende Diode" desselben Anmelders, eingereicht am 26.02.2003, näher erläutert.

Bei dieser Anwendung sind vorteilhafter Weise Leuchtdioden in nahezu beliebiger Vielfalt strukturierbar.

Das Basissubstrat ist insbesondere ein steifes Substrat, z.B. aus Glas oder einem organischen Träger. "Steif" ist im Sinne der Erfindung so zu verstehen, dass das Basissubstrat nicht um eine Walze oder Druckwalze mit einem vordefinierten Radius wickelbar ist. Es sind aber auch Substrate beschichtbar und/oder strukturierbar, die als Rollenware vorliegen, z.B. Folienbahnen.

Es liegt ferner im Rahmen,der Erfindung nacheinander unterschiedlich strukturierte Schutzschichten auf die herzustellende lichtemittierende Einrichtung aufzutragen und strukturiert zu fixieren, so dass Mehrfachstrukturen erzeugt werden können.

Gemäß einer ersten Ausführungsform der Erfindung wird die Schutzschicht mittels eines energiereichen Strahls strukturiert fixiert, wobei der energiereiche Strahl ein Laser- Strahl ist. Ferner kann die Strahlung kohärent oder inkohärent sein.

Bei einer strahlinduzierten, thermographischen, strukturierten Fixierung gemäß der ersten Ausführungsform wird mittels der Strahlung z.B. ein unstrukturiert aufgebrachtes Pulver nach dem Aufbringen, z.B. durch lokal definiertes Aufschmelzen auf der Oberfläche des Bauelements strukturiert. Die Struktur wird dabei gleichzeitig in einem Arbeitsschritt mit dem Fixieren erzeugt.

Bevorzugt wird die Schutzschicht durch ein- oder zweidimensionales Scannen des Strahls bevorzugt gerastert strukturiert fixiert.

Die Schutzschicht wird mittels eines Lasereinbrand-Verfahrens strukturiert fixiert wird, wobei vorteilhaft präzise Formen erzeugbar sind.

Die Lasereinbrand-Technik ist in der Druckschrift DE 43 26 947 C1, näher erläutert.

Gemäß einer zweiten Ausführungsform der Erfindung wird die Schutzschicht strukturiert auf die Oberfläche des Bauelements aufgebracht, mittels Elektrophotographie, also z.B. mit einem ggf. modifizierten Kopierer oder Laser-Drucker aufgedruckt.

Bei einem elektrophotographischen Drucker erfolgt die Ansteuerung über einen Raster Image-Processor direkt auf der Basis eines vollständig digital beschriebenen Druckauftrags über einen Zwischenträger, nämlich eine Bebilderungsoberfläche in Form einer photoleitenden Trommel, auf der nach Bebilderung mit Licht und Einfärbung ein Druckbild entsteht, das anschließend auf den Nutzträger übertragen wird.

Bei dieser Ausführungsform ist die Struktur der Schutzschicht also während des Aufbringens auf das Bauelement bereits ausgebildet oder vorhanden. Diese Ausführungsform gestattet daher eine besonders rationelle Verarbeitung.

Die Verfahren, welche unter anderem den vorgenannten Ausführungsformen zugrunde liegen, können in die Gruppe der Non-Impact-Verfahren oder Non-Impact-Druck-Verfahren eingeordnet werden. Dabei ist insbesondere ein Verfahren, bei welchem ein Photolack auf das Bauelement aufgetragen und zur Herstellung einer Ätzmaske mittels einer Belichtungsmaske photolithographisch belichtet und teilweise wieder abgelöst wird, nicht als Non-Impact-Verfahren zu verstehen.

Im Folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsformen miteinander kombiniert werden können.

### Kurzbeschreibung der Figuren

Es zeigen:
- Fig. 1: eine schematische Draufsicht auf ein Bauelement mit einer erfindungsgemäß strukturierten Schutzschicht gemäß einer ersten Ausführungsform der Erfindung,
- Fig. 2: einen schematischen Querschnitt entlang der Linie A-A in Fig. 1,
- Fig. 3: ein Bauelement mit einer strukturierten Lackschicht gemäß einem herkömmlichen Verfahren,
- Fig. 4a-4e: Schematische Querschnitte durch ein Bauelement gemäß einer zweiten Ausführungsform der Erfindung in unterschiedlichen Verfahrensstadien,
- Fig. 5a-5e: Schematische Querschnitte durch ein Bauelement gemäß einer dritten Ausführungsform der Erfindung in unterschiedlichen Verfahrensstadien,
- Fig. 6: eine schematische Darstellung einer erfindungsgemäßen ersten Lasereinbrandvorrichtung,
- Fig. 7: eine schematische Darstellung einer erfindungsgemäßen zweiten Lasereinbrandvorrichtung,
- Fig. 8a-8e: schematische Querschnitte durch ein Bauelement gemäß einer vierten Ausführungsform der Erfindung in verschiedenen Verfahrensstadien
- Fig. 9: eine schematische Darstellung einer piezoelektrisch arbeitenden Vorrichtung und
- Fig. 10: eine schematische Darstellung einer erfindungsgemäßen, elektrophotographisch arbeitenden Vorrichtung.

### Detaillierte Beschreibung der Erfindung

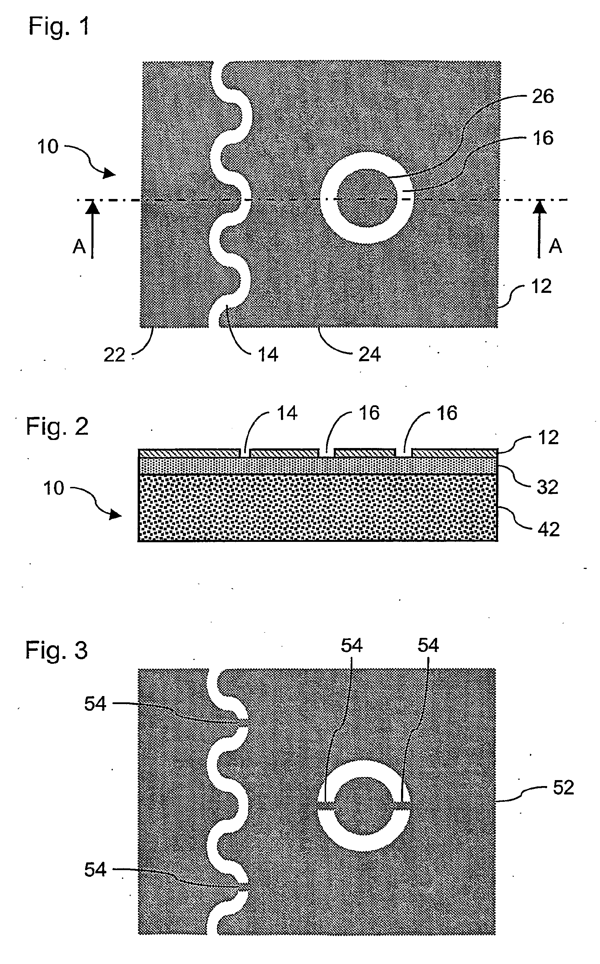

Fig. 1 zeigt die Draufsicht auf ein Bauelement 10 mit einer auf dessen Oberfläche strukturiert aufgebrachten Schutzschicht 12. Die Schutzschicht 12 weist als Strukturen eine durchgehende wellenförmige Aussparung 14 und eine kreisringförmige Aussparung 16 auf. Hierdurch ist die Schutzschicht 12 in drei separate und nicht zusammenhängende Abschnitte 22, 24, 26 aufgeteilt.

Fig. 2 zeigt einen Querschnitt durch das Bauteil 10 entlang der Achse A-A in Fig. 1. Die Schutzschicht 12 ist auf dem Bauteil 10, genauer unmittelbar auf einer Zwischen- oder Nutzschicht 32 aufgebracht, welche sich wiederum unmittelbar auf einem Basissubstrat 42 befindet.

Die Zwischenschicht 32 ist in diesem Beispiel eine durchsichtige elektrisch leitfähige Indium-Zinnoxid-Schicht (ITO) und das Basissubstrat 42 ist ein festes Glassubstrat.

Fig. 3 zeigt eine in herkömmlicher Weise mittels Belichtung über eine trägerfreie Metallfolienmaske hergestellte Photolackschicht 52. Unterbereiche der Photolackschicht 52 sind mittels Stegen 54 miteinander verbunden, was durch die Belichtungsmaske vorgegeben ist, da andernfalls die Belichtungsmaske nicht zusammenhalten würde.

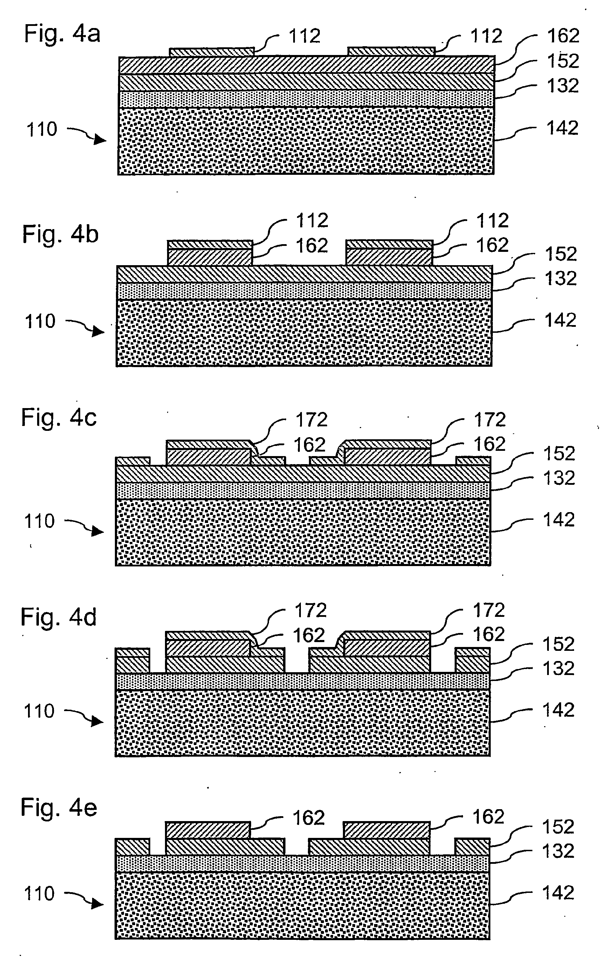

Die Figuren 4a bis 4e zeigen Querschnitte durch ein Bauelement 110, welches eine organische lichtemittierende Einrichtung oder Diode (OLED) gemäß einer zweiten Ausführungsform der Erfindung repräsentiert.

Bezugnehmend auf Fig. 4a ist das Bauelement 110 mit einer elektrisch leitfähigen Nutzschicht 132, einer ersten elektrolumineszenten Nutzschicht 152 und einer zweiten elektrolumineszenten Nutzschicht 162 auf einer Oberfläche eines Basissubstrats 142 dargestellt.

Alternativ kann z.B. die erste oder zweite Nutzschicht auch eine Funktionsschicht, z.B. eine Potentialanpassungsschicht, eine Blockierschicht oder eine Injektionsschicht sein. Derartige Funktionsschichten sind dem Fachmann grundsätzlich bekannt.

Unmittelbar auf einer Oberfläche der zweiten elektrolumineszenten Schicht 162 ist eine strukturierte Schutzschicht 112 aufgebracht, welche als Ätzmaske dient. Mit anderen Worten ist die Schutzschicht 112 auf dem Bauelement 110, bzw. mittelbar auf dem Basissubstrat 142 aufgebracht und fixiert.

In Fig. 4b ist das Bauelement 110 nach einem ersten Ätzschritt dargestellt; bei welchem das Bauelement 110, genauer die zweite elektrolumineszente Schicht 162 mittels der Schutzschicht oder Ätzmaske 112 strukturiert wurde.

Bezug nehmend auf Fig. 4c wird anschließend die Ätzmaske 112 abgelöst und eine zweite strukturierte Schutzschicht 172 auf das Bauelement 110, bzw. genauer auf die Oberfläche der von oben freiliegenden Schichten 152 und 162 aufgebracht. Alternativ kann die erste Schutzschicht 112 auch erhalten bleiben und die zweite Schutzschicht 172 noch auf diese aufgedruckt werden.

Bezugnehmend auf Fig. 4d wird in einem zweiten Ätzschritt die erste elektrolumineszente Schicht 152 mittels der strukturierten Ätzmaske 172 strukturiert weggeätzt.

Anschließend wird, wie in Fig. 4e dargestellt ist, die zweite Schutzschicht 172 abgelöst, so dass eine Mehrfachstruktur oder ein Schichtaufbau mit mehreren unterschiedlich strukturierten Schichten 152, 162 hergestellt ist.

Beispielsweise sind die erste und zweite elektrolumineszente Schicht 152, 162 verschiedenfarbig, so dass z.B. verschiedenfarbige, mehrfach strukturierte lichtemittierende Dioden (LED) mit dem erfindungsgemäßen Verfahren hergestellt werden können.

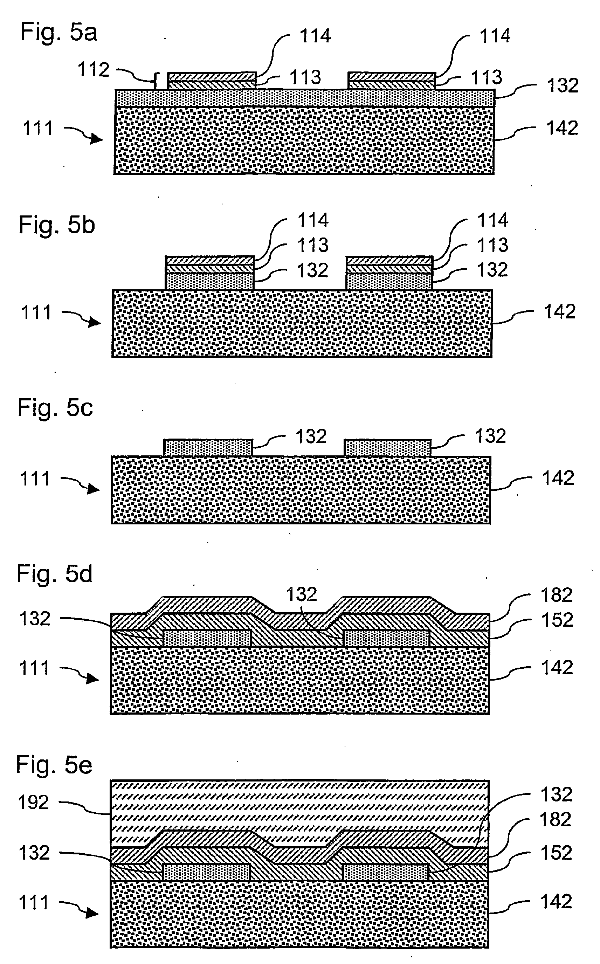

Die Fig. 5a bis 5e zeigen eine besonders bevorzugte Ausführungsform der Erfindung, gemäß welcher eine OLED 111 hergestellt wird.

Bezug nehmend auf Fig. 5a, wird zunächst das Basissubstrat 142 bereit gestellt und die erste transparente leitfähige Elektrodenschicht 132, z.B. aus einem transparenten leitfähigen Oxid (TCO) , insbesondere aus ITO auf das Basissubstrat 142 aufgebracht. Es wird unmittelbar auf die in diesem Verfahrensstadium noch unstrukturierte Elektrodenschicht 132 aus transparentem leitfähigen Material mittels eines Non-Impact-Verfahrens die Schutzschicht 112 aus geeignetem Tonermaterial strukturiert aufgedruckt.

Die strukturierte Schutzschicht 112 ist zweischichtig aufgebaut und umfasst eine strukturierte leicht ablösbare Schicht 113 und eine strukturierte ätzresistente Schicht 114. Die beiden Schichten enthalten diesbezüglich zwei unterschiedlich zusammengesetzte Tonermaterialien. Alternativ kann die Schutzschicht 112 auch aus mehr als zwei Schichten aufgebaut sein. Selbstverständlich liegen auch einschichtige Schutzschichten im Rahmen der Erfindung.

Die Schutzschicht 112, genauer die leicht ablösbare Schicht 113 ist direkt bzw. unmittelbar auf die erste transparente leitfähige Elektrodenschicht 132 aufgebracht. Es wurde nämlich überraschenderweise herausgefunden, dass die Leitfähigkeit der ersten oder unteren transparenten leitfähigen Elektrodenschicht 132 selbst, insbesondere bei der Verwendung von TCO, für die eingesetzten Druckverfahren, insbesondere in Kombination mit einem elektrophotographischen Druckverfahren, geeignet ist, um den Toner unmittelbar und ohne Zwischenschicht auf die untere transparente leitfähige Elektrodenschicht 132 aufzudrucken.

Bezug nehmend auf Fig. 5b wird nachfolgend mit einem konventionellen Ätzverfahren die untere transparente leitfähige Elektrodenschicht 132 teilweise weggeätzt, um diese zu strukturieren.

Bezug nehmend auf Fig. 5c wird nachfolgend die Schutzschicht oder Ätzmaskenschicht 112 entfernt.

Bezug nehmend auf Fig. 5d wird nachfolgend zunächst die elektrolumineszente Schicht 152, in diesem Beispiel unstruktutiert, auf die untere strukturierte ITO-Elektrodenschicht 132 aufgebracht und nachfolgend eine zweite oder obere transparente leitfähige .(ITO-) Elektrodenschicht 182 aufgebracht, so dass eine dem Fachmann grundsätzlich bekannte OLED-Schichtanordnung (TCO-elektrolumineszente Schicht-TCO) erzeugt wird. Ergänzend können weitere (Zwischen-) Schichten, z.B. zusätzliche elektrolumineszente Schichten und/oder eine oder mehrere Widerstandsschichten aufgebracht werden. Die elektrolumineszente Schicht 152 kann auch von einem Schichtpaket umfasst sein, welches z.B. noch eine oder mehrere Injektionsschichten, Blockierschichten und/oder Potentialanpassungsschichten umfasst.

Abschließend wird ein Decksubstrat 192, z.B. ein transparentes Glassubstrat aufgebracht, z.B. aufgeklebt, durch welches das erzeugte Licht ausgekoppelt wird. Alternativ oder ergänzend ist das Basissubstrat 142 ein Glassubstrat. Andere Kapselungsverfahren, z.B. eine Dünnschichtverkapselung sind auch möglich.

Die in den Fig. 5a bis 5e dargestellte Ausführungsform ist gegenüber der in Fig. 4a bis 4e dargestellten Ausführungsform technisch für die Herstellung von OLEDs noch vorteilhafter, da lediglich die erste oder untere leitfähige Elektrodenschicht 132 vor dem Aufbringen der sehr empfindlichen elektrolumineszenten OLED-Schicht 152, strukturiert wird. Demnach werden die Schritte des Aufdruckens der Ätz-Schutzschicht 112, des Ätzens und/oder des Entfernens der Ätz-Schutzschicht 112 durchgeführt, bevor die elektrolumineszente Schicht 152, d.h. die Schicht mit dem organischen, elektrolumineszenten Material 152 aufgebracht ist, so dass eine Verunreinigung der elektrolumineszenten Schicht(en) beim Drucken bzw. Ätzen wirksam vermieden werden kann.

Als Ergebnis wird eine strukturierte oder strukturiert lichtemittierende OLED 111 hergestellt.

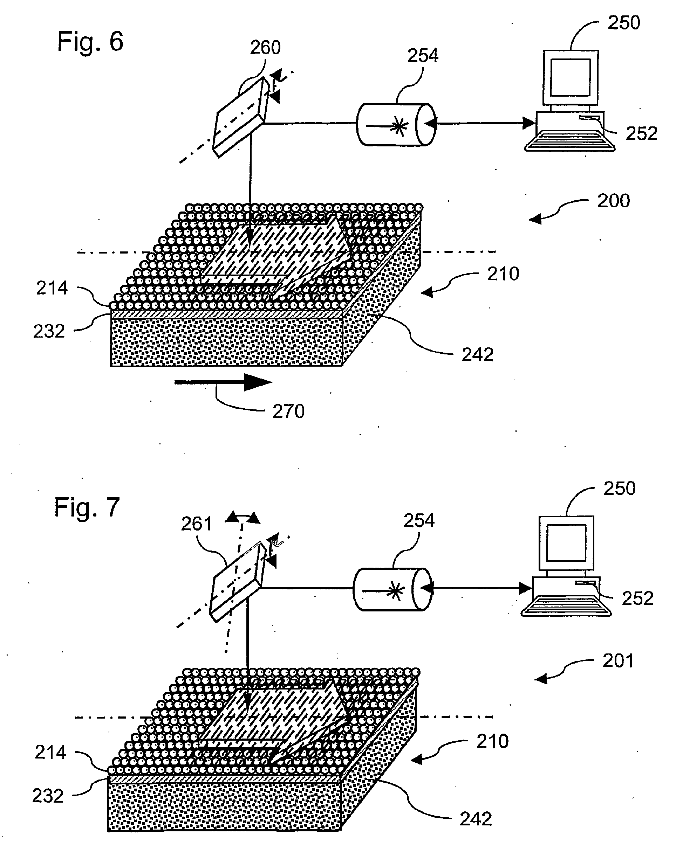

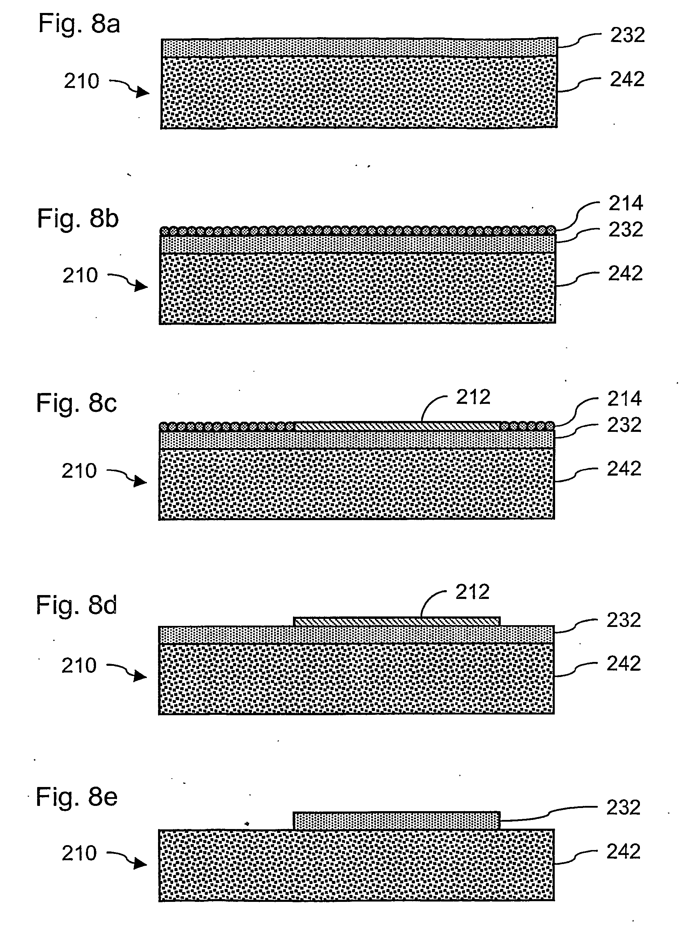

Fig. 6 zeigt eine erfindungsgemäße Ausführungsform einer Vorrichtung 200 zur Herstellung einer strukturierten Schutzschicht in Form einer sogenannten Lasereinbrandvorrichtung. Die einzelnen Verfahrensschritte der Herstellung einer strukturierten Oberfläche mittels der Vorrichtung 200 sind anhand von schematischen Querschnittdarstellungen durch ein Bauelement 210 in den Figuren 8a bis 8e gezeigt.

Wie am besten in Fig. 6 zu sehen ist, wird auf das Bauelement 210 in Form einer Unterlage, welche ein Basissubstrat 242 und eine Nutzschicht 232 umfasst, zunächst eine pulverförmige oder flüssige Schutz- oder Lackschicht aus Licht-härtbarem Lack 214 aufgebracht. Danach wird zum Verfestigen der Lackschicht ein Laserstrahl über das Bauelement bzw. die beschichtete Oberfläche der Unterlage 242 gescannt.

Um geeignete Strukturen, wie etwa den beispielhaft dargestellten Blockpfeil zu erzeugen, wird der Laserstrahl in Abhängigkeit vom Auftreffpunkt auf der Oberfläche moduliert. Dies geschieht, indem der Strahl über die Oberfläche gescannt und gleichzeitig entsprechend intensitätsmoduliert wird. Dazu wird die Intensität eines Lasers 254 von einer mit dem Laser verbundenen Recheneinrichtung 250 gesteuert, während der Laserstrahl durch, vorzugsweise eindimensionales Schwenken eines Schwenkspiegels 260, z.B. eines Polygonspiegels und Vorschieben der Unterlage entlang der Vorschubrichtung 270 über deren Oberfläche gescannt wird. Vorteilhaft wird auch der Schwenkspiegel und der Vorschub von der Recheneinrichtung gesteuert.

An den Stellen, an denen der Laserstrahl die Oberfläche trifft und den Lack 214 belichtet, tritt eine Verfestigung des Lacks ein. Es wird also der zunächst unstrukturiert aufgetragene Lack 214 durch die Bestrahlung mit dem Laser abschnittsweise oder strukturiert belichtet, so das in einem Abschnitt 212 eine Verfestigung des Lacks eintritt. Durch die Verfestigung wird der Lack auf der Nutzschicht 232 strukturiert fixiert.

Alternativ zu dem photobelichtbaren Lack kann auch ein duro- oder thermoplastisches Material 214 zur Erzeugung der Schutzschicht verwendet werden. In diesem Fall wird das Material 214 thermisch verschmolzen. Die Fixierung tritt dann z.B. durch eine Schmelzverklebung des Materials 214 mit einer Oberfläche der Nutzschicht 232 ein, wodurch die mechanische Haftung des Lacks auf der Oberfläche erhöht wird. Es ist jedoch auch denkbar die Schutzschicht mittels einer strukturierten Maske strukturiert zu fixieren.

Bezugnehmend auf Fig. 8d wird anschließend der nicht fixierte bzw. nicht verfestigte, noch pulverförmige Anteil des Lacks oder die unbehandelte Vorbeschichtung in einem Reinigungsschritt entfernt, so dass lediglich noch die fixierten Abschnitte 212 der Schutzschicht auf dem Bauelement verbleiben. Danach wird die Nutzschicht 232 strukturiert abgeätzt und abschließend der verfestigte Abschnitt der Schutzschicht entfernt. Das Ergebnis ist in Fig. 8e dargestellt.

Wieder Bezug nehmend auf Fig. 6 ist die Form der zu erzeugenden Struktur in einem Speicher 252 der Recheneinrichtung 250 abgelegt, wobei der Speicher noch eine Mehrzahl an weiteren andersartigen Strukturen enthalten kann, so dass für zwei aufeinanderfolgend aufzubringende Schutzschichten unterschiedliche Strukturen ladbar und erzeugbar sind. In dem Speicher ist eine digitale Beschreibung der zu druckenden Struktur abgelegt.

Fig. 7 zeigt eine gegenüber Fig. 6 modifizierte Ausführungsform einer Lasereinbrandvorrichtung 201. Die Vorrichtung 201 verwendet anstatt dem eindimensionalen Scannen des Laserstrahls quer zur Vorschubrichtung 270 ein zweidimensionales Scannen mittels eines zweidimensional schwenkbaren Spiegels 261. Demgemäß kann, falls gewünscht, auf den Vorschub 270 verzichtet werden.

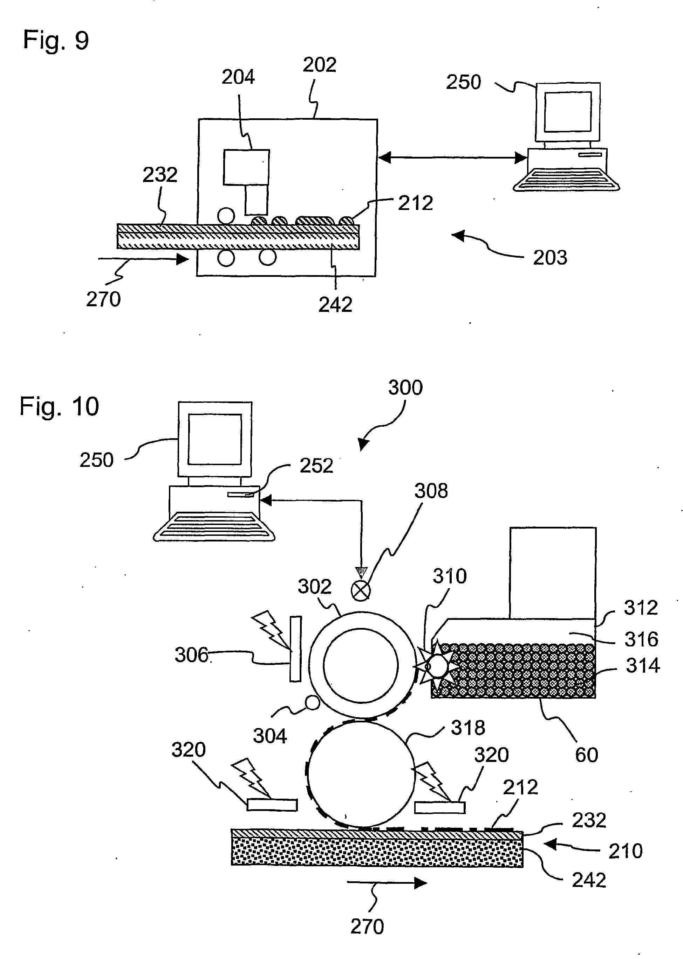

In Fig. 9 ist schematisch eine Non-Impact-Druckvorrichtung 203 (nicht Teil der Erfindung) zum Aufbringen einer strukturierten Schutzschicht auf eine Unterlage gezeigt. Die Vorrichtung umfaßt ebenfalls eine Recheneinrichtung 250. Die Recheneinrichtung 250 steuert eine Druckvorrichtung 202 mit einem Druckkopf 204. Als Druckkopf wird beispielsweise ein piezoelektrisch gesteuerter Strahl-Druckkopf verwendet, der mit einem geeigneten flüssigen und aushärtbaren Lack als Beschichtungsmaterial befüllt wird.

Das gewünschte Motiv der Leuchtfläche des Bauelements kann so direkt und maskenlos mittels der Recheneinrichtung 250 aus der Speichereinrichtung 252 mit der mit dieser verbundenen Druckvorrichtung 202 in Form einer strukturierten Schutzschicht 212 auf die Unterlage 242 übertragen werden.

Fig. 10 zeigt noch eine weitere, Ausführungsform einer Non-Impact-Druckvorrichtung 300 zum Auftragen einer strukturierten Schutzschicht 212 auf das Bauelement 210. Die in Fig. 10 dargestellte Ausführungsform verwendet eine elektrophotographische Übertragung einer ätzresistenten Maskenschicht 212 auf die Nutzschicht 232. Die Funktionsweise der Vorrichtung 300 entspricht zum Teil der eines Laserdruckers oder Kopierers.

Eine Bildtrommel 302 rotiert und deren Oberfläche wird zunächst an einer Reinigungs- und Löschlichteinheit 304 und anschließend an einem geladenen Ladekoroton 306 vorbeibewegt, wodurch dieses Ladung an die Bildtrommel 302 abgibt und die Oberfläche der Bildtrommel 302 gleichmäßig beispielsweise negativ aufgeladen wird. Die aufgeladene Oberfläche der Bildtrommel wird dann durch deren Rotation an einer Leuchtdioden-Anordnung 308 vorbeibewegt. Diese wird wiederum von einer Recheneinrichtung 250 angesteuert, so daß die Bildtrommel 302 entsprechend dem auf die Oberfläche des Bauelements 210 zu übertragenen Motivs belichtet wird. An den belichteten Stellen wird die Ladung an der Oberfläche abgeleitet, so daß die Bildtrommel ein unsichtbares elektrisches Abbild des Motivs erhält.

Mit einer Magnetbürste 310 einer Entwicklungseinheit 312 wird dann Toner 314 aus einem Tonervorratsbehälter 316 auf die Bildtrommel 302 übertragen. Dies beschreibt die Tonerübertragung bei einem 2-Komponenten-System, bei dem die Toner-Teilchen mittels sogenannter Carrier-Teilchen an die Bildtrommel übertragen werden. Es sind auch nichtmagnetische 1-Komponenten-Toner einsetzbar, bei denen die Entwicklung rein elektrostatisch erfolgt. Zwischen der Bildtrommel 302 und der Entwicklungseinheit 312 wird dazu außerdem eine Biasspannung gelegt. Der Toner haftet nur an den durch die Belichtung entladenen Bereichen der Bildtrommel 302. Anders als bei einem Laserdrucker wird aber der Toner nicht direkt von der Bildtrommel 302 auf die Unterlage übertragen. Da das Basissubstrat 242 im allgemeinen aus einem vergleichsweise harten Material, wie beispielsweise aus Glas besteht, wird der Toner 314 von der Bildtrommel 302 zunächst auf eine Transfertrommel 318 und erst dann auf das Bauelement 210 übertragen. Die Transfertrommel 318 weist eine weiche und/oder elastische Oberfläche, wie etwa aus Gummi auf, die sich der Oberfläche des Bauelements 210 gut anpassen kann, so daß ein guter Kontakt des Bauelements zum Toner auf der Transfertrommel 318 erreicht wird.

Die Unterlage wird vorteilhaft mit einem Übertragungskoroton 320 ebenfalls gleichmäßig aufgeladen, so daß der Toner von der Transfertrommel 318 abgezogen wird. Anstelle einer Aufladung mittels eines Übertragungskorotons 320 kann eine uniforme Aufladung auch einfach durch direkten elektrischen Kontakt mit einer Spannungsquelle erzielt werden, wenn die Oberfläche des Bauelements 210, z.B. aufgrund einer vorangegangenen Beschichtung mit einer leitfähigen Nutzschicht 232, leitfähig ist und die Ladung sich gleichmäßig verteilt.

Alternativ kann der Toner auch thermisch während des Übertrags auf dem vorgeheizten Basissubstrat fixiert werden. Dies kann auch ohne zusätzliche Spannung an der ITO-Schicht durchgeführt werden. In diesem Fall kann auf ein Übertragungskoroton 320 verzichtet werden.

In einem nachfolgenden Fixiervorgang wird die mit dem Toner beschichtete Oberfläche auf eine moderate Temperatur unterhalb von 250°C, typischerweise zwischen 120 und 180°C, erwärmt und der Toner fixiert oder verfestigt. Es ist dem Fachmann ersichtlich, dass der Toner beim Fixieren bereits strukturiert auf dem Bauelement aufgetragen ist.

Dieser Vorgang des Aufbringens der Schutzschicht 212 mit zumindest einer Struktur gemäß diesem Beispiel ist unter anderem deshalb von Vorteil, da die Beschichtung vergleichsweise schnell durchgeführt werden kann und eine Trocknungsphase entfällt.

Mit einem derartigen elektrophotographischen Beschichtungsverfahren, welches auch als Computer-to-Glass-(CTG) Verfahren bezeichnet wird, läßt sich eine laterale Auflösung der Struktur von etwa 20 µm erreichen. Es kann sowohl ein Graustufendruck mit variabler Schichtdicke, etwa mit einer Schichtdicke zwischen 1 µm und 8 µm, als auch ein Rasterdruck durchgeführt werden. Durch den Fixiervorgang mit einem thermischen Aufschmelzen der Tonerpartikel kommt es insbesondere auch zu einer Verrundung des Kantenbereiches, so daß steile Flanken der Strukturen nicht auftreten.

Durch mehrfache Wiederholung des Druckvorgangs kann auch leicht eine Mehrfachstruktur der Schutzschicht so aufgebracht werden, daß sie Bereiche mit stufenweise unterschiedlicher Schichtdicke und/oder unterschiedlichen Beschichtungsmaterialien oder Lacken aufweist. In vorteilhafter Weise kann die Schutzschicht zwei oder mehrschichtig aufgebaut sein. Hierbei hat es sich als günstig erwiesen eine leicht ablösbare erste Schicht und eine darauf aufgebrachte stabile und widerstandsfähige ätzresistente zweite Ätzschutzschicht vorzusehen. Dadurch wird eine leichte Entfernbarkeit mit hoher Ätzresistenz kombiniert.

Die erfindungsgemäß hergestellten Bauelemente lassen sich in vorteilhafter Weise in vielen Bereichen einsetzen. Als Beispiele für die möglichen Anwendungsgebiete sind hier Automotive, Telekommunikation, Mobiltelefone, Haustechnik, insbesondere white goods und/oder brown goods, Spielwaren, Anzeigen, Werbung, Signage, Embleme oder Logos genannt.

## Patentansprüche

1. Verfahren zur Herstellung einer lichtemmitierenden Einrichtung, insbesondere einer OLED, umfassend die Schritte
Bereitstellen eines Substrats (142), Aufbringen zumindest einer ersten transparenten leitfähigen Elektrodenschicht (132), einer elektrolumineszenten Schicht (152) und einer zweiten transparenten leitfähigen Elektrodenschicht (182), derart, dass eine lichtemittierende Schichtanordnung gebildet wird,
Erzeugen einer strukturierten Ätzmaske (12, 112, 212) auf einer ersten der Schichten (132, 152, 182) der lichtemittierenden Schichtanordnung, und
Strukturieren dieser ersten Schicht (132, 152, 182),
**dadurch gekennzeichnet,**
i) **daß** die Ätzmaske (12, 112, 212) aus Toner (314) mittels eines elektrophotographischen Verfahrens (300) erzeugt wird, wobei der Toner (314) von einer Bildtrommel (302) über eine Transfertrommel (318) auf der besagten ersten Schicht (132, 152, 182) der lichtemmitierenden Schichtanordnung strukturiert aufgedruckt wird oder dadurch
ii) **daß** pulverförmiges oder flüssiges Material (214) auf der besagten ersten Schicht (132, 152, 182) der lichtemmitierenden Schichtanordnung aufgebracht wird, und mittels eines Lasereinbrandverfahrens (200, 201) die Ätzmaske aus dem Material (214) auf der besagten ersten Schicht strukturiert fixiert wird, indem ein Laserstrahl, welcher das Material (214) härtet oder verschmilzt über das Bauelement gescannt wird.

2. Verfahren nach Anspruch 1,
**dadurch gekennzeichnet, dass**
die Ätzmaske unmittelbar auf einer der Schichten der lichtemittierenden Schichtanordnung aufgebracht wird.

3. Verfahren nach einem der vorstehenden Ansprüche,
**dadurch gekennzeichnet, dass** die Ätzmaske unmittelbar auf die erste transparente leitfähige Schicht (132) aufgebracht wird.

4. Verfahren nach einem der vorstehenden Ansprüche,
**dadurch gekennzeichnet, dass** die Ätzmaske (12, 112, 212) vor dem Aufbringen der elektrolumineszenten Schicht (152) aufgebracht wird.

5. Verfahren nach einem der vorstehenden Ansprüche,
**dadurch gekennzeichnet, dass**
das Strukturieren der lichtemittierenden Einrichtung (10, 110, 111, 210) ein Ätzen umfasst.

6. Verfahren nach einem der vorstehenden Ansprüche,
**dadurch gekennzeichnet, dass**
als strukturierte Ätzmaske (12, 112, 212) eine Ätzmaske aufgebracht wird.

7. Verfahren nach einem der vorstehenden Ansprüche,
**dadurch gekennzeichnet, dass**
die Ätzmaske (12, 112, 212) nach dem Strukturieren der lichtemittierenden Einrichtung (10, 110, 111, 210) abgelöst wird.

8. Verfahren nach einem der vorstehenden Ansprüche,
**dadurch gekennzeichnet, dass**
die Ätzmaske (12, 112, 212) zumindest zeitweise mit einer Schicht der lichtemittierenden Einrichtung (10, 110, 111, 210) flächig strukturiert verbunden ist.

9. Verfahren nach einem der vorstehenden Ansprüche,
**dadurch gekennzeichnet, dass**
die Ätzmaske (12, 112, 212) zumindest zeitweise mit einer Schicht der lichtemittierenden Einrichtung (10, 110, 111, 210) ablösbar verbunden wird.

10. Verfahren nach einem der vorstehenden Ansprüche,
**dadurch gekennzeichnet, dass**
dass die mechanische Haftung der Ätzmaske (12, 112, 212) auf einer Schicht der lichtemittierenden Einrichtung (10, 110, 111, 210) mittels des Fixierens der Ätzmaske (12, 112, 212) erhöht wird.

11. Verfahren nach einem der vorstehenden Ansprüche,
**dadurch gekennzeichnet, dass**
die Ätzmaske (12, 112, 212) thermisch, mechanisch, mittels elektromagetischer Strahlung, oder chemisch reaktiv fixiert wird.

12. Verfahren nach einem der vorstehenden Ansprüche,
**dadurch gekennzeichnet, dass**
die Ätzmaske (12, 112, 212) durch Erwärmung über 50°C und unter 500°C fixiert wird.

13. Verfahren nach einem der vorstehenden Ansprüche,
**dadurch gekennzeichnet, dass**
die Ätzmaske (12, 112, 212) mittels eines Vernetzens, Verklebens, Verschmelzens oder Abscheidens fixiert wird.

14. Verfahren nach einem der vorstehenden Ansprüche,
**dadurch gekennzeichnet, dass**
eine Ätzmaske (12, 112, 212) aus thermoplastischem oder duroplastischem Material (214, 314) aufgebracht wird.

15. Verfahren nach einem der vorstehenden Ansprüche,
**dadurch gekennzeichnet, dass**
eine Ätzmaske (12, 112, 212) in formbarem oder fluidem Zustand auf eine Schicht der lichtemittierenden Einrichtung (10, 110, 111, 210) aufgetragen wird.

16. Verfahren nach einem der vorstehenden Ansprüche,
**dadurch gekennzeichnet, dass**
die Ätzmaske (12, 112, 212) ein ZweiKomponentengemisch, ein Monomer, ein Polymer, ein Sol-Gel, ein Pulver, Nanopartikel, oder eine Folie umfasst.

17. Verfahren nach einem der vorstehenden Ansprüche,
**dadurch gekennzeichnet, dass**
die strukturierte Ätzmaske (12, 112, 212) nicht-zusammenhängende Bereiche umfasst.

18. Verfahren nach einem der vorstehenden Ansprüche,
**dadurch gekennzeichnet, dass**
die strukturierte Ätzmaske (12, 112, 212) mittels eines Graudruckverfahrens lokal mit vordefiniert unterschiedlichen Schichtdicken erzeugt wird.

19. Verfahren nach einem der vorstehenden Ansprüche,
**dadurch gekennzeichnet, dass**
die digitale Beschreibung der Struktur der strukturierten Ätzmaske (12, 112, 212) in einem elektronischen Speicher (252) gespeichert ist und zum strukturierten Fixieren der Ätzmaske (12, 112, 212) auf der lichtemittierenden Einrichtung (10, 110, 111, 210) aus dem Speicher (252) geladen wird.

20. Verfahren nach einem der vorstehenden Ansprüche,
**dadurch gekennzeichnet, dass**
die lichtemittierende Einrichtung (10, 110, 111, 210) ein Substrat (42, 142, 242) aus Glas, Keramik, Glaskeramik, Kristall oder einen organischen Träger umfasst.

21. Verfahren nach einem der vorstehenden Ansprüche,
**dadurch gekennzeichnet, dass**
nacheinander unterschiedlich strukturierte Ätzmaskeen (112, 172) zur Erzeugung von Mehrfachstrukturen (152, 162) auf eine Schicht der lichtemittierenden Einrichtung (10, 110, 111, 210) aufgebracht werden.

22. Verfahren, **dadurch gekennzeichnet, dass**
das Verfahren gemäß einem der vorstehenden Ansprüche mehrfach nacheinander durchgeführt wird, um nacheinander mehrere Bauteile zu strukturieren.

23. Verfahren nach einem der vorstehenden Ansprüche,
**dadurch gekennzeichnet, dass**
die Dauer des Verfahrens zwischen dem Bereitstellen des Substrats (42, 142, 242) und dem strukturierten Fixieren der Ätzmaske (12, 112, 212) auf einer Schicht der lichtemittierenden Einrichtung (10, 110, 111, 210) weniger als 30 min beträgt.

24. Verfahren nach einem der vorstehenden Ansprüche,
**dadurch gekennzeichnet, dass**
die Ätzmaske (12, 112, 212) mittels eines energiereichen Strahls (254) strukturiert fixiert wird.

25. Verfahren nach einem der vorstehenden Ansprüche,
**dadurch gekennzeichnet, dass**
die Ätzmaske (12, 112, 212) mittels Scannen (260, 261) strukturiert fixiert wird.

26. Verfahren nach einem der vorstehenden Ansprüche,
**dadurch gekennzeichnet, dass**
die Ätzmaske (214) unstrukturiert aufgetragen wird und nachfolgend auf einer Oberfläche des Bauteils strukturiert wird.

27. Verfahren nach einem der vorstehenden Ansprüche,
**dadurch gekennzeichnet, dass** die Struktur der Ätzmaske beim Aufbringen der Ätzmaske auf die lichtemittierende Einrichtung (10, 110, 111, 210) bereits ausgebildet ist.

28. Verfahren nach einem der vorstehenden Ansprüche,
**dadurch gekennzeichnet, dass** die Struktur der Ätzmaske während des Aufbringens der Ätzmaske auf eine Schicht der lichtemittierenden Einrichtung (10, 110, 111, 210) erzeugt wird.

29. Verwendung einer nach dem Verfahren gemäß einem der vorstehenden Ansprüche hergestellten strukturierten lichtemittierenden Einrichtung für Automobile, Telekommunikation, Mobiltelefone, Haustechnik, insbesondere white goods und/oder brown goods, Spielwaren, Anzeigen, Werbung, Signage, Embleme oder Logos.

## Claims

1. A method for manufacturing a light emitting device, in particular an OLED, comprising the steps of:
providing of substrate (142),
applying at least a first transparent conductive electrode layer (132), an electroluminescent layer (152), and a second transparent conductive electrode layer (182) in such a manner that a light emitting layer structure is formed,
producing a patterned etching mask (12, 112, 212) on a first one of said layers (132, 152, 182) of the light emitting layer structure, and
patterning said first layer (132, 152, 182), **characterized in**
i) **that** the etching mask (12, 112, 212) is produced from toner (314) using an electro-photographical process (300), wherein said toner (314) is printed in patterned form from an image drum (302) via a transfer drum (318) to said first layer (132, 152, 182) of the light emitting layer structure, or
ii) **that** a powdered or liquid material (214) is applied to said first layer (132, 152, 182) of the light emitting layer structure, and the etching mask of said material (214) is fixed in patterned form on said first layer using a laser baking process (200, 201) in which the device is scanned by a laser beam which cures or fuses said material (214).

2. The method of claim 1, **characterized in that** the etching mask is directly applied to one of the layers of the light emitting layer structure.

3. The method according to any of the preceding claims, **characterized in that** the etching mask is directly applied to the first transparent conductive layer (132).

4. The method according to any of the preceding claims, **characterized in that** the etching mask (12, 112, 212) is applied prior to applying the electroluminescent layer (152).

5. The method according to any of the preceding claims, **characterized in that** patterning of the light emitting device (10, 110, 111, 210) comprises etching.

6. The method according to any of the preceding claims, **characterized in that** an etching mask is applied as a patterned etching mask (12, 112, 212).

7. The method according to any of the preceding claims, **characterized in that** said etching mask (12, 112, 212) is removed following patterning of the light emitting device (10, 110, 111, 210).

8. The method according to any of the preceding claims, **characterized in that** the etching mask (12, 112, 212) is connected, at least temporarily, to a layer of the light emitting device (10, 110, 111, 210) in two-dimensionally patterned form.

9. The method according to any of the preceding claims, **characterized in that** the etching mask (12, 112, 212) is removably connected, at least temporarily, to a layer of the light emitting device (10, 110, 111, 210).

10. The method according to any of the preceding claims, **characterized in that** mechanical adhesion of the etching mask (12, 112, 212) to a layer of the light emitting device (10, 110, 111, 210) is enhanced by fixing the etching mask (12, 112, 212).

11. The method according to any of the preceding claims, **characterized in that** the etching mask (12, 112, 212) is fixed in thermal manner, mechanically, by means of electromagnetic radiation, or in chemically reactive manner.

12. The method according to any of the preceding claims, **characterized in that** the etching mask (12, 112, 212) is fixed by heating to above 50°C and below 500°C.

13. The method according to any of the preceding claims, **characterized in that** the etching mask (12, 112, 212) is fixed by cross-linking, gluing, fusing or depositing.

14. The method according to any of the preceding claims, **characterized in that** an etching mask (12, 112, 212) is applied from thermoplastic or duroplastic material (214, 314).

15. The method according to any of the preceding claims, **characterized in that** an etching mask (12, 112, 212) is applied to a layer of the light emitting device (10, 110, 111, 210) in moldable or fluid condition.

16. The method according to any of the preceding claims, **characterized in that** the etching mask (12, 112, 212) comprises one of a two-component mixture, a monomer, a polymer, a sol-gel, a powder, nanoparticles, or a film.

17. The method according to any of the preceding claims, **characterized in that** the patterned etching mask (12, 112, 212) comprises non-contiguous sections.

18. The method according to any of the preceding claims, **characterized in that** the patterned etching mask (12, 112, 212) is produced using a grey print process, with locally predefined different layer thicknesses.

19. The method according to any of the preceding claims, **characterized in that** a digital description of the pattern of the patterned etching mask (12, 112, 212) is stored in an electronic memory (252) and is reloaded from said memory (252) for fixing the etching mask (12, 112, 212) in patterned form on the light emitting device (10, 110, 111, 210).

20. The method according to any of the preceding claims, **characterized in that** the light emitting device (10, 110, 111, 210) comprises a substrate (42, 142, 242) of glass, ceramic, glass ceramic, crystal, or an organic carrier.

21. The method according to any of the preceding claims, **characterized in that** differently patterned etching masks (112, 172) are successively applied to a layer of the light emitting device (10, 110, 111, 210), for producing multiple structures (152, 162).

22. A method **characterized in that** the method according to any of the preceding claims is repeated several times, for successively patterning a plurality of devices.

23. The method according to any of the preceding claims, **characterized in that** the duration of the method from providing the substrate (42, 142, 242) until fixing the etching mask (12, 112, 212) in patterned form to a layer of the light emitting device (10, 110, 111, 210) is shorter than 30 min.

24. The method according to any of the preceding claims, **characterized in that** the etching mask (12, 112, 212) is fixed in patterned form by means of a high energy beam (254).

25. The method according to any of the preceding claims, **characterized in that** the etching mask (12, 112, 212) is fixed in patterned form by scanning (260, 261).

26. The method according to any of the preceding claims, **characterized in that** the etching mask (214) is applied in non-patterned form, and is subsequently patterned on a surface of the device.

27. The method according to any of the preceding claims, **characterized in that** the pattern of the etching mask is already formed as the etching mask is applied to the light emitting device (10, 110, 111, 210).

28. The method according to any of the preceding claims, **characterized in that** the pattern of the etching mask is produced while applying the etching mask to a layer of the light emitting device (10, 110, 111, 210).

29. Use of a patterned light emitting device produced according to any of the preceding claims, for automobile, telecommunication, mobile phones, domestic appliances, in particular white goods and/or brown goods, toys, displays, advertising, signage, emblems, or logos.

## Revendications

1. Procédé pour fabriquer un dispositif émetteur de lumière, en particulier une OLED, comprenant les étapes suivantes :
mise à disposition d'un substrat (142),
application d'au moins une première couche d'électrodes (132) transparente et conductrice, d'une couche (152) électroluminescente et d'une seconde couche d'électrodes (182) transparente et conductrice, de telle sorte qu'un agencement de couches émettant de la lumière est formé,
génération d'un masque de gravure (12, 112, 212) structuré sur une première des couches (132, 152, 182) de l'agencement de couches émetteur de lumière, et
structuration de cette première couche (132, 152, 182),
**caractérisé en ce que**
i) le masque de gravure (12, 112, 212) est généré à partir de toner (314) au moyen d'un procédé (300) électrophotographique, le toner (314) étant imprimé de façon structurée par un tambour d'image (302) au moyen d'un tambour de transfert (318) sur ladite première couche (132, 152, 182) de l'agencement de couches émetteur de lumière, et/ou
ii) **en ce que** du matériau (214) pulvérulent ou liquide est appliqué sur ladite première couche (132, 152, 182) de l'agencement de couches émetteur de lumière, et le masque de gravure à base du matériau (214) est fixé au moyen d'un procédé de pénétration au laser (200, 201) sur ladite première couche, un faisceau laser, qui durcit ou fait fondre le matériau (214), étant scanné sur le composant.

2. Procédé selon la revendication 1, **caractérisé en ce que**
le masque de gravure est appliqué directement sur l'une des couches de l'agencement de couches émetteur de lumière.

3. Procédé selon l'une des revendications précédentes,
**caractérisé en ce que** le masque de gravure est appliqué directement sur la première couche (132) transparente et conductrice.

4. Procédé selon l'une des revendications précédentes, **caractérisé en ce que** le masque de gravure (12, 112, 212) est appliqué avant l'application de la couche (152) électroluminescente.

5. Procédé selon l'une des revendications précédentes, **caractérisé en ce que**
la structuration du dispositif (10, 110, 111, 210) émetteur de lumière comprend un décapage.

6. Procédé selon l'une des revendications précédentes, **caractérisé en ce que**
un masque de gravure est appliqué comme masque de gravure (12, 112, 212) structuré.

7. Procédé selon l'une des revendications précédentes, **caractérisé en ce que**
le masque de gravure (12, 112, 212) est décollé après la structuration du dispositif émetteur de lumière (10, 110, 111, 210).

8. Procédé selon l'une des revendications précédentes, **caractérisé en ce que**
le masque de gravure (12, 112, 212) est relié à plat de façon structurée au moins temporairement à une couche du dispositif (10, 110, 111, 210) émetteur de lumière.

9. Procédé selon l'une des revendications précédentes,
**caractérisé en ce que** le masque de gravure (12, 112, 212) est relié de façon amovible au moins temporairement à une couche du dispositif (10, 110, 111, 210) émetteur de lumière.

10. Procédé selon l'une des revendications précédentes, **caractérisé en ce que** l'adhérence mécanique du masque de gravure (12, 112, 212) sur une couche du dispositif (10, 110, 111, 210) émetteur de lumière est augmentée au moyen de la fixation du masque de gravure (12, 112, 212).

11. Procédé selon l'une des revendications précédentes, **caractérisé en ce que** le masque de gravure (12, 112, 212) est fixé de façon thermique, mécanique au moyen de rayonnement électromagnétique ou par réactivité chimique.

12. Procédé selon l'une des revendications précédentes, **caractérisé en ce que**
le masque de gravure (12, 112, 212) est fixé par réchauffement au-dessus de 50°C et au-dessous de 500°C.

13. Procédé selon l'une des revendications précédentes, **caractérisé en ce que**
le masque de gravure (12, 112, 212) est fixé au moyen d'une réticulation, d'un collage, d'une fusion ou d'un découpage.

14. Procédé selon l'une des revendications précédentes, **caractérisé en ce que**
un masque de gravure (12, 112, 212) à base de matériau (214, 314) thermoplastique ou duroplastique est appliqué.

15. Procédé selon l'une des revendications précédentes, **caractérisé en ce que**
un masque de gravure (12, 112, 212) est appliqué dans un état moulable ou fluide sur une couche du dispositif (10, 110, 111, 210) émetteur de lumière.

16. Procédé selon l'une des revendications précédentes, **caractérisé en ce que**
le masque de gravure (12, 112, 212) comprend un mélange de deux composants, un monomère, un polymère, un sol-gel, une poudre, des nanoparticules ou un film.

17. Procédé selon l'une des revendications précédentes, **caractérisé en ce que**
le masque de gravure (12, 112, 212) structuré comprend des zones non cohérentes.

18. Procédé selon l'une des revendications précédentes, **caractérisé en ce que**
le masque de gravure (12, 112, 212) structuré est généré au moyen d'un procédé d'impression en gris localement avec des épaisseurs de couches différentes de façon prédéfinie.

19. Procédé selon l'une des revendications précédentes, **caractérisé en ce que**
la description numérique de la structure du masque de gravure (12, 112, 212) structuré est stockée dans une mémoire (252) électronique et est chargée pour la fixation structurée du masque de gravure (12, 112, 212) sur le dispositif (10, 110, 111, 210) émetteur de lumière à partir de la mémoire (252).

20. Procédé selon l'une des revendications précédentes, **caractérisé en ce que**
le dispositif (10, 110, 111, 210) émetteur de lumière comprend un substrat (42, 142, 242) en verre, céramique, vitrocéramique, cristal ou un support organique.

21. Procédé selon l'une des revendications précédentes, **caractérisé en ce que**
des masques décapants (112, 172) structurés différemment de façon successive et destinés à générer des structures multiples (152, 162) sont appliqués sur une couche du dispositif (10, 110, 111, 10) émetteur de lumière.

22. Procédé, **caractérisé en ce que** le procédé est mis en oeuvre selon l'une des revendications précédentes plusieurs fois de façon successive, afin de structurer plusieurs composants de façon successive.

23. Procédé selon l'une des revendications précédentes, **caractérisé en ce que** la durée du procédé entre la mise à disposition du substrat (42, 142, 242) et la fixation structurée du masque de gravure (12, 112, 212) sur une couche du dispositif (10, 110, 111, 210) émetteur de lumière est inférieure à 30 minutes.

24. Procédé selon l'une des revendications précédentes, **caractérisé en ce que**
le masque de gravure (12, 112, 212) est fixé de façon structurée au moyen d'un faisceau (254) riche en énergie.

25. Procédé selon l'une des revendications précédentes, **caractérisé en ce que**
le masque de gravure (12, 112, 212) est fixé de façon structurée par scannage (260, 261).

26. Procédé selon l'une des revendications précédentes, **caractérisé en ce que**
le masque de gravure (214) est appliqué de façon non structurée et est structuré ensuite sur une surface du composant.

27. Procédé selon l'une des revendications précédentes, **caractérisé en ce que** la structure du masque de gravure est déjà réalisée lors de l'application du masque de gravure sur le dispositif (10, 110, 111, 210) émetteur de lumière.

28. Procédé selon l'une des revendications précédentes, **caractérisé en ce que** la structure du masque de gravure est générée pendant l'application du masque de gravure sur une couche du dispositif (10, 110, 111, 210) émetteur de lumière.

29. Utilisation d'un dispositif émetteur de lumière structuré, fabriqué selon l'une des revendications précédentes, pour les automobiles, la télécommunication, les téléphones mobiles, les équipements ménagers, en particulier des "white goods" et/ou des "brown goods", des jeux, des affichages, la publicité, les "signages", les emblèmes ou les logos.
